Europäisches Patentamt

European Patent Office

Office européen des brevets

(19)

(11) Publication number: **0 338 417**
**A2**

# EUROPEAN PATENT APPLICATION

(12)

(21) Application number: **89106576.5**

(51) Int. Cl.⁴: **C03C 17/245**

(22) Date of filing: **13.04.89**

(30) Priority: **18.04.88 US 182643**
**05.07.88 US 219691**
**05.07.88 US 219692**
**05.07.88 US 215141**

(43) Date of publication of application:
**25.10.89 Bulletin 89/43**

(84) Designated Contracting States:
**BE CH DE ES FR GB IT LI LU SE**

(71) Applicant: **PPG INDUSTRIES, INC.**
**One PPG Place**
**Pittsburgh Pennsylvania 15272(US)**

(72) Inventor: **Bloss, Karl Heinrich**
**515 Squire Place**
**Pittsburgh, Pa. 15237(US)**
Inventor: **Davis, James Arthur**
**343 Route 366**
**Apollo, Pa. 15613(US)**
Inventor: **Neuman, George Andrew**
**1128 Sheffield Street Apt. 202**
**Pittsburgh, PA. 15233(US)**
Inventor: **Harmon, Peter Paul**
**2611 Farmspur Road**
**North Huntingdon, PA. 15642(US)**

(74) Representative: **Sternagel, Hans-Günther, Dr.**
**et al**
**Patentanwälte Dr. Michael Hann Dr. H.-G.**
**Sternagel Sander Aue 30**
**D-5060 Bergisch Gladbach 2(DE)**

(54) Haze-free infrared-reflecting coated glass.

(57) Chlorine-free organotin coating compositions are disclosed, along with methods for preparing them and methods for pyrolyzing them to form haze-free tin oxide films on the surfaces of substrates.

EP 0 338 417 A2

## HAZE-FREE INFRARED-REFLECTING COATED GLASS

Background of the Invention

The present invention relates generally to the art of infrared-reflecting coated glass products, and more particularly to non-irridescent, high transmittance, low emissivity, infrared-reflecting coated glass products.

. Transparent infrared-reflecting films such as tin oxide may be deposited on a substrate such as glass by a variety of methods, including the application of thermally decomposable compounds to a heated surface. Useful methods for forming transparent infrared-reflecting tin oxide films are taught in U.S. Patent No. 3,107,177 to Saunders et al, U.S. Patent No. 3,677,814 to Gillery, and U.S. Patent No. 4,263,335 to Wagner et al.

Tin oxide films are especially effective infrared reflectors at thicknesses of about 1000 to 8000 Angstroms. However, at such thicknesses the films tend to display interference effects, i.e., multiple visible colors commonly referred to as iridescence. These interference effects render the coated glass aesthetically unacceptable for most architectural applications. Iridescence is not observed in thinner films; however, these films have insufficient infrared reflectance to be practically useful. Likewise, iridescence is not observed in thicker films; however, these films tend to be hazy and difficult to make uniformly. Therefore, various methods to mask interference effects have been developed.

U.S. Patent No. 3,710,074 to Stewart discloses an electrically heated multiple glazed window unit having an electroconductive coating on an enclosed surface and a selective reflecting film having an absolute infrared reflectance of at least 0.7 to improve the heat insulating character of the unit and reduce the visible iridescence of the conductive film.

U.S. Patent No. 4,069,630 to Chess et al discloses a heat reflecting multiple glazed window comprising a colored, heat absorbing exterior glass sheet having a heat reflecting tin oxide film on its interior surface, and an interior glass sheet which may be either clear glass or colored. The tin oxide film typically has an interference color from first order red to fourth order red, the visual effect of which is attenuated by the colored heat absorbing glass.

U.S. Patent Nos. 4,187,336; 4,206,252 and 4,308,316 to Gordon disclose transparent glass window structures comprising a glass sheet bearing a first coating of infrared reflective material, wherein the observance of iridescence resulting from the first coating is reduced by a second coating of particular refractive index and thickness providing at least two interfaces forming means to reflect and refract light to interfere with the observance of iridescence.

U.S. Patent No. 4,377,613 to Gordon discloses transparent window structures comprising a glass sheet bearing a coating of infrared reflective material wherein the observance of iridescence is reduced by provision of a very thin coating system beneath the infrared reflective coating with reflects and refracts light to interfere with the observation of iridescence.

U.S. Application Serial No. 768,922 filed August 23, 1985, by V. A. Henery et al discloses an alternative method for masking the visible interference effects of an infrared reflecting film in a window unit, which involves masking the visible interference effects of an infrared reflecting film by means of a second film having a uniform reflectance in the visible wavelength range combined with a luminous reflectance which is significantly higher than that of the infrared reflecting film. To product a high transmittance, low emissivity unit, the thickness of the infrared reflecting film is preferably chosen to correspond with the first minimum in the reflectance curve.

U.S. Patent No. 3,759,743 to Menke discloses an improved technique for producing electrically conducting tin oxide films on the surface of a ceramic substrate by applying a solution of an organotin salt of trifluoroacetic acid to the substrate while it is at a temperature above 800° F.

Summary of the Invention

The present invention provides a method for producing haze-free infrared reflective tin oxide films by the oxidative pyrolysis of a halogen free coating reactant, specifically tributyltin dimethylpropionate, also known as tributyltin trimethylacetate, tributyltin neopentanoate or tributyltin pivalate; bis-tributyltin oxide; and butyltin acetates, such as tributyltin acetate. The present invention further provides a method for producing haze-free infrared reflective tin oxide films by chemical vapor deposition surface-catalyzed combustion of a chlorine-free fluorine-containing organotin coating reactant, such as alkyltin fluoroalkanoates, fluoroalkenoates, fluoroalkynoates or multifunctional fluoroalkenynoates (fluoroalknoates), specifically tributyltin

2

trifluoroacetate and tributyltin heptafluorobutyrate.


Brief Description of the Drawings

Figure 1 exhibits the vapor pressure of tributyltin dimethyl propionate in accordance with the present invention.

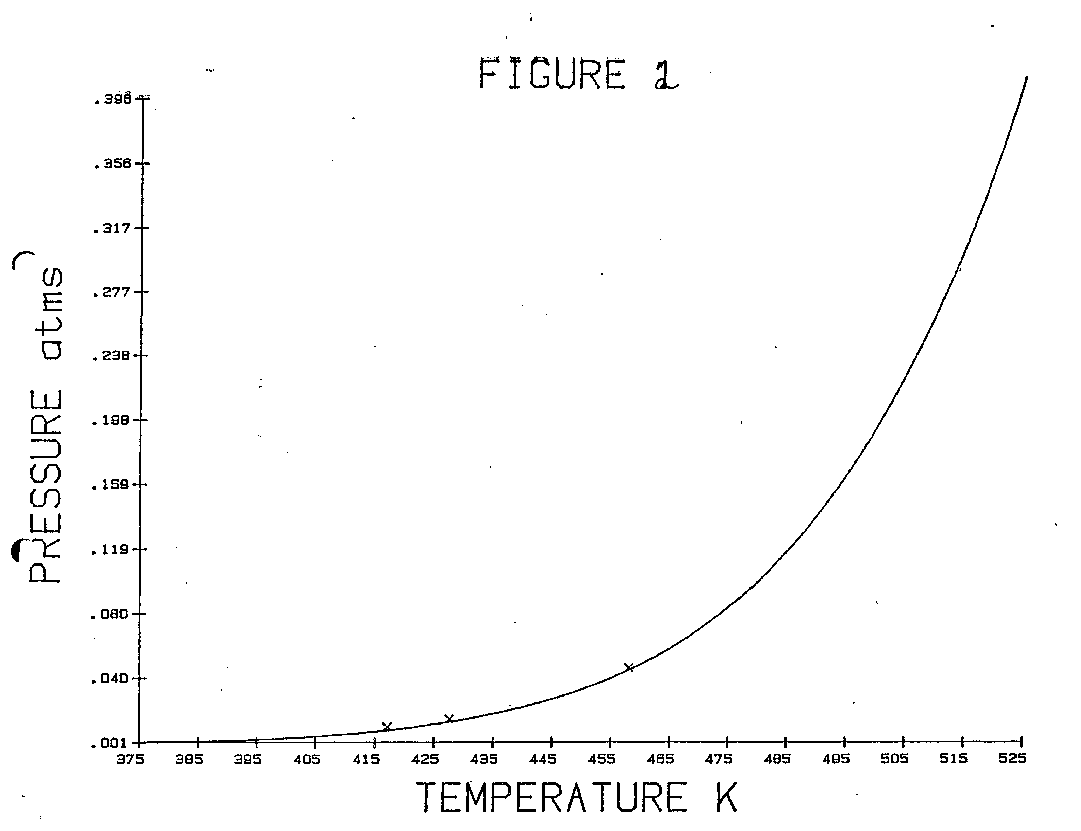

Figure 2 exhibits the vapor pressure of tributyltin acetate in accordance with the present invention.

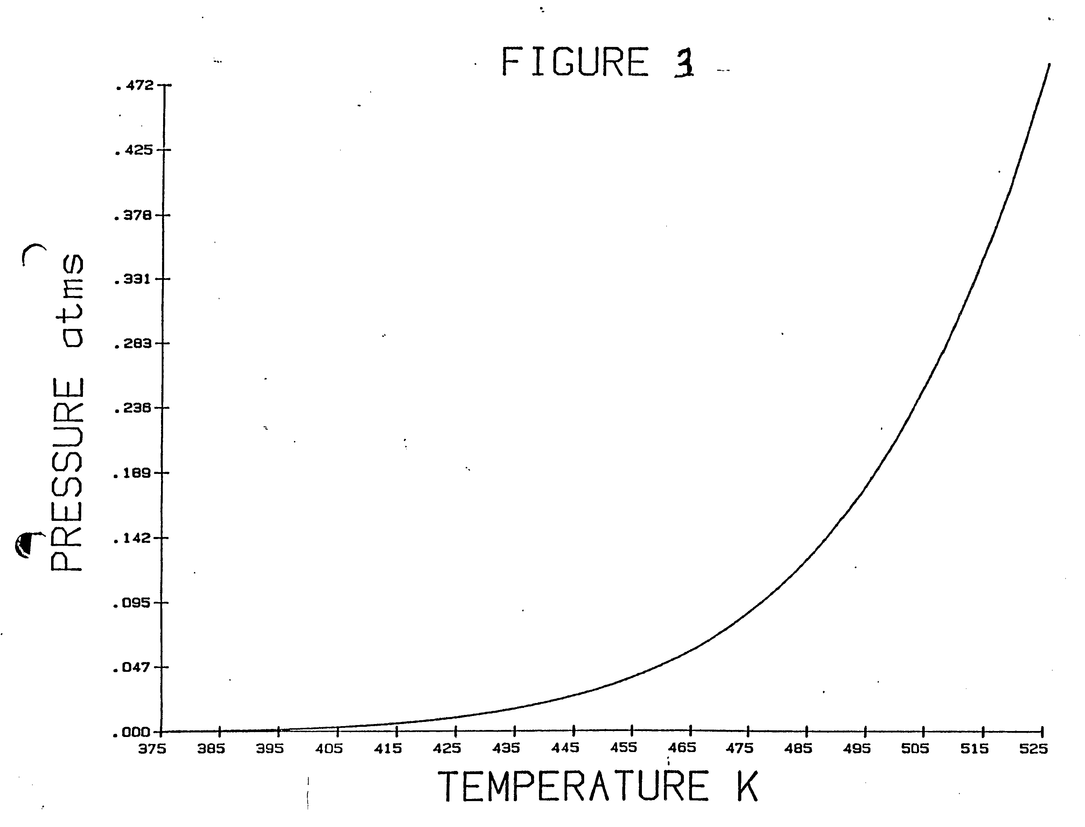

. Figure 3 exhibits the vapor pressure curve of tributyltin trifluoroacetate in accordance with the present invention.


Description of the Preferred Embodiments

Infrared reflecting films exhibiting visible interference effects may be useful on a monolithic sheet. Preferred articles in accordance with the present invention are multiple glazed window units comprising at least two panes, preferably both glass. Conventional glass compositions are useful, especially typical soda-lime-silica glass produced on a float line. Heat absorbing tinted glasses may be employed; but for high transmittance applications, clear glass is preferred.

Of the various infrared reflecting films which may be useful for solar energy control in accordance with the present invention, tin oxide is preferred. Tin oxide films may be deposited on glass surfaces by a variety of methods such as pyrolytic deposition, powder coating, chemical vapor deposition and cathode sputtering. Suitable methods include pyrolysis of alkyltin fluorides as taught in U.S. Patent Nos. 3,677,814 to Gillery and 4,263,335 to Wagner et al; chemical vapor deposition as taught in U.S. Patent No. 3,850,679 to Sopko et al; powder coating as taught in U.S. Patent No. 4,325,988 to Wagner and No. 4,344,986 to Henery; and cathode sputtering as taught in U.S. Patent Nos. 3,477,936 and 3,506,556 to Gillery et al.

Preferred tin oxide infrared reflecting films in accordance with the present invention have a resistivity less than about 50 ohms per square, more preferably in the range of 20 to 30 ohms per square, and a low emissivity, preferably less than 0.4. The thickness of the film is chosen to correspond with a minimum in the luminous reflectance curve. Preferably, the film thickness corresponds to the first minimum since this point represents the lowest visible reflectance obtainable for a tin oxide film. This point corresponds with the second order blue interference effect at a thickness of about 1400 Angstroms. Coating process parameters are adjusted to yield the minimum resistivity for the given thickness to provide maximum infrared reflectance and minimum emissivity. If lower resistivity is desired for higher solar energy performance, a thicker infrared reflecting tin oxide film may be formed, preferably at a thickness near the second minimum in the luminous reflectance curve, most preferably at the thickness corresponding with the third order blue interference effect, about 2750 Angstroms.

In the preferred embodiment wherein the thickness of the tin oxide infrared reflecting film corresponds with the first minimum in the special reflectance curve, the film typically appears blue by interference effects, the visible reflectance is about 10 percent, and the resistivity is generally about 45 to 50 ohms per square.

Articles in accordance with the present invention are effective for passive solar heating applications because the high transmittance allows solar energy (light and heat) into a structure, while the high infrared reflectance and low emissivity keep heat inside the structure from being lost. Because the coating reactant of the present invention is halogen-free, the tin oxide films of the present invention are free of haze caused by reaction of chlorine with sodium from the glass.

Higher performance coatings may be formed by doping the tin oxide with fluorine. For example, fluorine containing compounds such as trifluoroacetic acid may be added, preferably about 1 to 10 percent by weight, most preferably about 5 percent. Because some of the coating reactants of the present invention contain fluorine, the conductivity of the chemical vapor deposition tin oxide films of these is higher than for non-fluorinated compositions. A preferred fluoroalknoate is tributyltin trifluoroacetate. The present invention will be further illustrated in detail by the specific examples which follow.


EXAMPLE 1


· A clear float glass substrate is heated in a furnace at 1300° F (about 704° C) for about 4 minutes. The hot glass is then passed at a line speed of 280 inches (about 7.1 meters) per minute past a slot shaped nozzle with a nozzle width of 0.125 inch (about 3.175 millimeters) spaced 0.25 inch (about 6.35 millimeters) above the glass surface. The nozzle is supplied with bis-tributyltin oxide vaporized at 490° F (about 254° C) carried in air at a rate of 20 cubic feet per minute. A tin oxide coating is deposited which exhibits 0.0% haze when analyzed using a Gardner XL211 Hazeguard System with the illuminant "C" filter.

## EXAMPLE 2

To 1.5 kilogram of ambient-temperature bis-tributyltin oxide, available from Aldrich Chemicals, is added 580 grams of dimethylpropionic acid, available from Exxon as neopentanoic acid, which is in a liquid state at approximately 40° C. The two-phase liquid is heated with magnetic stirring in a reaction flask equipped with a reflux condenser. The mildly exothermic reaction is completed within about one hour maintaining a gentle reflux. The reflux condenser is then replaced with a distillation head, through which water and some excess dimethylpropionic acid is distilled off. When the contents of the reaction/distillation flask begin to roil, the distillation is continued at lower pressures. The atmospheric-pressure operation is terminated near 150° C liquid temperature. After removal of foreruns, the main fraction, tributyltin dimethylpropionate, distills sharply at 154/1° C and 7 torr gage (about 9 torr in-flask pressure) as a water-clear liquid. The yield is about 1.8 to 1.9 kilograms. Upon prolonged standing at ambient, or shortly at refrigerator temperatures, the liquid reaction product congeals to a waxy mass of crystals.

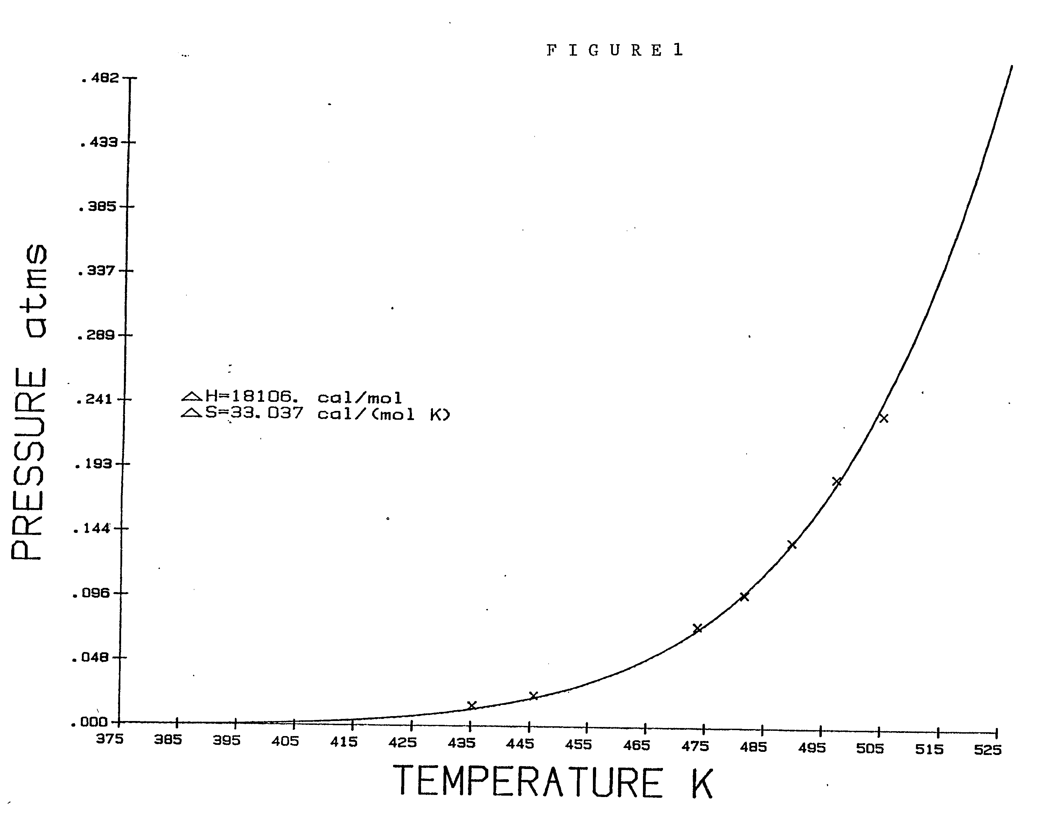

A vapor pressure curve of the newly synthesized tributyltin pivalate is obtained by the boiling reflux method, and is attached as Figure 1. From these data, the enthalpy and entropy of vaporization are calculated to be 18.7 kilocalories per mole and 34.41 calories per mole-K respectively.

## EXAMPLE 3

A tin oxide film is deposited from the above tributyltin pivalate by chemical vapor deposition as follows. Tributyltin pivalate is vaporized, and carried in air at a concentration of 1 torr. The vapor is delivered at a rate of 2 centimeters per second in a classic cold-wall reactor to a glass substrate at a temperature of 950° F (about 510° C). A thin film having a resistance of 1200 ohms is formed.

## EXAMPLE 4

In order to improve the conductivity of tin oxide films deposited from tributyltin pivalate, trifluoroacetic acid is added at 5 percent by weight. A glass substrate is heated in a furnace at 1265° F (about 685° C) for four and a half minutes. The glass, traveling at 300 inches (about 7.6 meters) per minute, has a temperature of 1169° F (about 632° C) at the coating nozzle, which is spaced 0.25 inch (6.35 millimeters) from the glass surface to be coated. The coating reactant flow rate is 97.5 cubic centimeters per minute, and the air supply flow rate to the vaporizer is 16 cubic feet per minute. The air supplied to the vaporizer is heated from about 81° F (about 27° C) to 375° F (about 191° C). The hot air and coating reactant mixture is heated in the vaporizer, and coating vapor exits at a temperature of about 374° F (about 190° C). Upon contact with the hot glass surface, the coating vapor reacts to form a fluorine-doped tin oxide film which has a uniform amber color, indicating a thickness of 900 to 1000 Angstroms, and a resistance of 86 ohms per square.

## EXAMPLE 5

A tin oxide film is deposited as in the previous example except that the glass speed is 240 inches (about 6.1 meters) per minute, the glass is heated for 5 minutes in a furnace at 1280° F (about 693° C) to produce a glass temperature at the coater nozzle of 1186° F (about 641° C). Carrier air at 85° F (about 29° C) is supplied to the vaporizer at 12 cubic feet per minute. The coating vapor temperature is 367° F (about 186° C). A slightly thicker tin oxide film is formed. A first order red interference color indicates a film thickness of about 1200 to 1300 Angstroms, and the resistance is 42 ohms per square.

The above examples are offered only to illustrate the present invention. Optimization of the coating apparatus, process parameters, and composition are excepted to provide even lower resistance haze-free films and are included within the scope of the invention. The transmittance, reflectance and resistance values may be altered by varying the relative coating thicknesses or by controlling coating process parameters in accordance with the various known coating techniques. The scope of the present invention is defined by the following claims.

## EXAMPLE 6

Tributyltin acetate is preferably synthesized from bis-tributyltin oxide as follows. Ambient-temperature bis-tributyltin oxide, available from Aldrich Chemicals, is heated to 45°C. To 596 grams (one mole) of the bis-tributyltin oxide is slowly added 122.4 grams (2 moles) of glacial acetic acid. The temperature of the mixture rises to about 70°C as a solid reaction product is formed. The mixture is heated to about 125°C to melt the reaction product and drive off water formed in the reaction. After 30 minutes, the reaction mixture is allowed to cool and solidify. The powder reaction product is dried in a vacuum desicator. The melting point of the tributyltin acetate thus produced is about 79 to 81°C. The decomposition temperature is determined to be 280°C in nitrogen and 140°C in air. The enthalpy of vaporization is calculated to be 15,450 calories per mole, and the entropy of vaporization 27.590 calories per mole K. A clear float glass substrate is heated in a furnace at 1300°F (about 704°C) for about 4 minutes. The substrate passes at a line speed of 280 inches (about 7.1 meters) per minute past a slot shaped nozzle 0.125 inch (8.175 millimeters) wide placed 0.25 inch (6.35 millimeters) above the hot glass surface. A coating solution comprising 250 grams of tributyltin acetate in 500 milliliters of methanol is vaporized at a temperature of about 165 to 175°C and carried in air at a flow rate of 20 cubic feet per minute to the glass surface. A tin oxide film is formed on the glass surface at a temperature of 1080°F (about 582°C). The coating has a luminous reflectance of 12 percent and chromaticity coordinates of x = .2906 and y = .2999.

## EXAMPLE 7

A clear float glass substrate is coated as in the previous example except with a higher flow rate of coating reactant. A tin oxide film is formed with a luminous transmittance of 16 percent and chromaticity coordinates of x = .2852 and y = .2926.

## EXAMPLE 8

A clear float glass sample is coated as in Example 6 except that the glass is heated for about four and a half minutes to provide a surface temperature of 1109°F (about 598°C) and the vapor temperature is lowered to 135 to 150°C. A tin oxide film is formed with a luminous transmittance of 13 percent and chromaticity coordinates of x = .2890 and y = .2965.

## EXAMPLE 9

A clear glass substrate is coated in a bench scale kinetic coater using tributyltin acetate vapor carried in air. The tributyltin acetate concentration is 0.23 percent, and the flow rate of the vapor stream is 5 centimeters per second. The glass surface temperature is 1050°F (about 566°C), and the substrate is exposed to the vapor stream for 3 minutes. A haze free tin oxide film is formed.

## EXAMPLE 10

A clear glass substrate is coated as in the previous Example except that the flow rate is 10 cm/sec. A thicker haze free tin oxide film is formed.

## EXAMPLE 11

A clear glass substrate is coated as in the previous Example except that the flow rate is 15 cm/sec and the concentration of tributyltin acetate is 0.22 percent. A thicker haze free tin oxide film is formed.

## EXAMPLE 12

A clear glass substrate is coated as in the previous Example except that the flow rate is 20 cm/sec and the concentration of tributyltin acetate is 0.21 percent. A thicker haze free tin oxide film is formed.

## EXAMPLE 13

A clear glass substrate is coated as in the previous Example except that the flow rate of the vapor stream is 25 cm/sec. A thicker haze free tin oxide film is formed.

## EXAMPLE 14

A clear glass substrate is coated as in the previous Example except that the flow rate is 34.5 cm/sec and the concentration of tributyltin acetate is 0.20 percent. A thicker haze free tin oxide film is formed.

The coated glass samples from Examples 4 to 14 range in thickness from 500 to more than 5000 Angstroms. The thicker films produced with the higher velocity flow rates are more uniform. Since there is no fluorine present, the conductivity of these samples is not very high, with resistivities ranging from 3000 to 1000 ohms per square, varying with thickness. Fluorine doping is preferred to bring the conductivity into the desired range of less than 50 ohms per square.

## EXAMPLE 15

A clear float glass substrate is heated at 1300° F (about 704° C) to provide a surface temperature of 1121° F (about 605° C). The substrate is coated as in the previous examples except that the coating composition is dibutyltin diacetate carried in nitrogen. A haze-free tin oxide film is formed having a luminous reflectance of 13 percent and chromaticity coordinates of x = .2892 and y = .2968.

## EXAMPLE 16

A clear float glass sample is prepared as in the previous example except that the flow rate of the dibutyltin diacetate is higher. A haze-free tin oxide film is formed having a luminous reflectance of 18 percent and chromaticity coordinates of x = .2873 and y = .2954.

## EXAMPLE 17

A clear float glass substrate is coated as in Example 10 except that the glass surface is at 1117° F (about 603 °C) and the dibutyltin diacetate is carried in air. A haze free tin oxide film is formed having a luminous transmittance of 14 percent and chromaticity coordinates of x = .2875 and y = .2949.

EXAMPLE 18

A clear float glass substrate is coated as in Example 6 except that the surface temperautre is 1121 °F (about 605 °C) as in Example 5 and the flow rate of dibutyltin diacetate is higher than in Examples 5 and 6. A haze free tin oxide coating is formed with a luminous reflectance of 20 percent and chromaticity coordinates of x = .2892 and y = .2968.

EXAMPLE 19

To 0.5 kg of ambient-temperature trifluoroacetic acid in a three-liter flask equipped with a stirrer and a reflux condenser, 1.3 kg of bis-tributyltin oxide is added within 10 to 15 minutes to induce and sustain a gentle reflux. After 10 to 15 more minutes of refluxing with heating, the stirrer is withdrawn. Cooling the contents of the flask to ambient for separation of liquid by-products is optional. Volatiles are removed by heating the crude tributyltin trifluoroacetate, first at atmospheric, then at reduced pressure, to approximately 150 °C. Pure tributyltic trifluoroacetate distils at 124±2C/2 torr and congeals near 80 °C to a white, waxy mass of long, needly crystals. Solidification of the distillates in the condensers should be avoided. The decomposition temperature of tributyltin trifluoroacetate is determined to be 280 °C in nitrogen and 150 °C in air. The enthalpy of vaporization is calculated to be 15,248 calories per mole, and the entropy of vaporization 26.789 calories per mole K. Higher homologs such as tributyltin pentafluoropropionate, heptafluorobutyrate, and so on, are synthesized analogously. Their properties are similar; e.g. tributyltin perfluorobutyrate boils at 124±2 °C/1.3 torr. A glass substrate is coated on a bench scale kinetic coater using tributyltin trifluoroacetate as the coating reactant. The tributyltin trifluoroacetate is vaporized and carried in air. The concentration of tributyltin trifluoroacetate in air is 0.005 percent. The coating reactant vapor/carrier air mixture is delivered to the glass surface at a flow rate of 2 centimeters per second. The glass substrate is exposed to the vapor stream for 9 minutes with the glass surface temperature at 1170 °F (about 632 °C). A haze-free tin oxide film is formed.

EXAMPLE 20

A glass substrate is coated as in Example 19 except that the flow rate is 13.5 cm/sec and the glass surface temperature is 1250 °F (about 677 °C). A haze-free tin oxide film is formed.

EXAMPLE 21

A glass substrate is coated as in Examples 19 and 20 except that the flow rate is 25 cm/sec and the glass surface temperature is 1290 °F (about 699 °C). A haze-free tin oxide film is formed.

EXAMPLE 22

A glass substrate is coated as in the previous Examples except that the flow rate is 50 cm/sec and the glass surface temperature is 1200 °F (about 649 °C). A haze-free tin oxide film is formed.

EXAMPLE 23

A glass substrate is coated as in the previous Examples except that the flow rate is 75 cm/sec and the glass surface temperature is 1320° F (about 716° C). A haze-free tin oxide film is formed.

EXAMPLE 24

A glass substrate is coated as in the previous Examples except that the flow rate is 25 cm/sec and the glass surface temperature is 1260° F (about 682° C). A haze-free tin oxide film is formed.

The coatings of the above examples range in thickness from 500 to 3000 Angstroms. The conductivity of the films varies with the thickness and ranges from 120 to 10 ohms per square. The following table summarizes the reaction conditions for the above examples.

TABLE I

| Example | Flow Rate | Coating Concentration | Glass Temperature | |
|---------|-----------|----------------------|-----------|-----------|
| (No.) | (cm/sec) | (% in air) | (° F) | (° C) |
| 19 | 2.0 | .005 | 1170 | 632 |
| 20 | 13.5 | .005 | 1250 | 677 |
| 21 | 25.0 | .005 | 1290 | 699 |
| 22 | 50 0 | .005 | 1200 | 649 |
| 23 | 75.0 | .005 | 1320 | 716 |
| 24 | 25.0 | .01 | 1260 | 682 |

Claims

1. A method of forming a tin oxide coating comprising contacting a surface of a substrate in an oxidizing atmosphere with a chlorine-free organotin compound at a temperature sufficient to thermally react said chlorine-free organotin compound to deposit a tin oxide film on said surface, wherein said chlorine-free organotin compound is selected from the group consisting of tributyltin dimethylpropionate, bis-tributyltin oxide, butyltin acetate and alkyltin fluoroalknoate.

2. A method according to claim 1, wherein said substrate is glass.

3. A method according to claim 2, wherein said chlorine-free organotin compound is in vapor form.

4. A method according to claim 3, wherein said vapor is combined with a carrier gas to form a mixture.

5. A method according to claim 4, wherein said carrier gas is air.

6. A method according to claim 5, wherein said alkyltin fluoroalknoate is selected from the group consisting of alkyltin fluoroalkanoates, alkyltin fluoroalkenoates, alkyltin fluoroalkynoates and mixtures thereof.

7. A method according to claim 5, wherein said chlorine-free organotin compound comprises a halogen-free organotin compound selected from the group consisting of tributyltin dimethyl propionate, bis-tributyltin oxide, tributyltin acetate and dibutyltin acetate.

8. A method according to claim 7, wherein said mixture further comprises a fluorine-containing compound.

9. A method according to claim 8, wherein said fluorine containing compound is trifluoroacetic acid.

10. A method according to claim 9, wherein said mixture comprises about 1 to 10 percent by weight trifluoroacetic acid based on the weight of chlorine-free organotin compound.

FIGURE 1

FIGURE 1

EP 0 338 417 A2

FIGURE 3